# EUROPEAN PATENT APPLICATION

(11) **EP 4 626 163 A1**
(43) Date of publication of application: **01.10.2025**
(21) Application number: 25165336.6
(22) Date of filing: 21.03.2025
(51) Int. Cl.: H05K 7/20

(54) **A HEAT DISSIPATING DEVICE FOR A PCB**

(30) Priority: 22.03.2024 IN 202421022297
(71) Applicant: Vertiv Corporation, Westerville, OH 43082 (US)
(72) Inventor: NATARAJAN, Srinivasan, 638501 Erode (IN); PAITHANE, Manoj J., 411036 Pune (IN); CHARAPALE, Utkarsh Diliprao, 416114 Kolhapur (IN)
(74) Representative: Beal, James Michael

(57) **Abstract**

A heat dissipating device configured to dissipate heat generated by heat generating components of a PCB includes: an arm extending from a trace of the PCB proximate a heat generating component; and a plurality of flanges extending from the arm, wherein air flowing from a fan disposed on the PCB interacts with the plurality of flanges causing the plurality of flanges to remove heat from the heat generating component.

## Description

### CROSS REFERENCE TO RELATED APPLICATIONS

This Patent Application claims the benefit of Indian Provisional Patent Application Serial No. 202421022297 titled "A Heat Dissipating Device For A PCB" filed March 22, 2024.

### FIELD

This invention relates to a printed circuit boards (PCBs) and mechanisms used for facilitating heat dissipation of the PCBs.

### BACKGROUND

The background information herein below relates to the present disclosure but is not necessarily prior art.

A printed circuit board (PCB) has various electronic components such as capacitors, transformers, IGBPs, etc. mounted thereon. Typically, heat generated by these components is dissipated by air conducted through the PCB. However, certain components such as diodes of a relatively smaller dimensions, have a comparatively higher heat density. Due to their relatively smaller height, it becomes difficult to efficiently pass air there over for the purpose of cooling, thus making it equally challenging for maintaining the safe operating limits of these components despite providing copper trace on the PCB for helping with dissipation of heat.

There is therefore felt a need for a device that alleviates the aforementioned drawbacks.

### SUMMARY

An aspect of the disclosed embodiments includes a heat dissipating device configured to dissipate heat generated by heat generating components of a printed circuit board (PCB). The heat dissipating device includes: an arm extending from a trace of the PCB proximate a heat generating component; and a plurality of flanges extending from the arm, wherein air flowing from a fan disposed on the PCB interacts with the plurality of flanges causing the plurality of flanges to remove heat from the heat generating component.

An aspect of the disclosed embodiments includes a heat dissipating device configured to dissipate heat generated by heat generating components of a PCB. The heat dissipating device includes: a trapezoidal housing extending from a trace of the PCB proximate a heat generating component, wherein the trapezoidal housing includes: a first opening disposed at a first end of the trapezoidal housing; and a second opening disposed at a second end of the trapezoidal housing, wherein the first opening is larger than the second opening.

An aspect of the disclosed embodiments includes a heat dissipating device configured to dissipate heat generated by heat generating components of a PCB. The heat dissipating device includes: a trapezoidal housing extending from a trace of the PCB proximate a heat generating component; and a heat sink disposed on at least a portion of the heat generating component.

### BRIEF DESCRIPTION OF THE ACCOMPANYING DRAWING

A heat dissipating device, of the present disclosure, for a PCB will now be described with the help of the accompanying drawing, in which:
Figure 1A illustrates an isometric view of a PCB having a plurality of heat generating components located thereon;
Figure 1B illustrates a front view of the PCB with the heat generating components and copper traces extending therefrom;
Figure 1C illustrates a right side view of the PCB with the heat generating components;
Figure 1D illustrates a top view of the PCB with the heat generating components;
Figure 2A illustrates an isometric view of a device mounted on the PCB;
Figure 2B illustrates a front view of the device mounted on the PCB;
Figure 2C illustrates a right side view of the device mounted on the PCB;
Figure 2D illustrates a top view of the device mounted on the PCB;
Figure 3A illustrates an isometric view of a device mounted on the PCB;
Figure 3B illustrates a front view of the device mounted on the PCB;
Figure 3C illustrates a right side view of the device mounted on the PCB;
Figure 3D illustrates a top view of the device mounted on the PCB;
Figure 4A illustrates an isometric view of a device mounted on the PCB;
Figure 4B illustrates a front view of the device mounted on the PCB;
Figure 4C illustrates a right side view of the device mounted on the PCB;
Figure 4D illustrates a top view of the device mounted on the PCB;
Figure 5A illustrates an isometric view of a device mounted on the PCB;
Figure 5B illustrates a front view of the device mounted on the PCB;
Figure 5C illustrates a right side view of the device mounted on the PCB;
Figure 5D illustrates a top view of the device mounted on the PCB; and
Figure 6 illustrates a graph representing the surface temperature of the heat generating component achieved with the help of each embodiment of the device.

### DETAILED DESCRIPTION

Embodiments are provided so as to thoroughly and fully convey the scope of the present disclosure to the person skilled in the art. Numerous details are set forth, relating to specific components, and methods, to provide a complete understanding of embodiments of the present disclosure. It will be apparent to the person skilled in the art that the details provided in the embodiments should not be construed to limit the scope of the present disclosure. In some embodiments, well- known processes, well-known apparatus structures, and well-known techniques are not described in detail.

The terminology used, in the present disclosure, is only for the purpose of explaining a particular embodiment and such terminology shall not be considered to limit the scope of the present disclosure. As used in the present disclosure, the forms "a", "an" and "the" may be intended to include the plural forms as well, unless the context clearly suggests otherwise. The terms "comprises", "comprising", "including", "includes" and "having" are open-ended transitional phrases and therefore specify the presence of stated features, elements, modules, units and/or components, but do not forbid the presence or addition of one or more other features, elements, components, and/or groups thereof.

Embodiments, of the present disclosure, will now be described with reference to the accompanying drawing.

In some embodiments, the systems and methods described herein may be configured to provide a heat dissipating device for a printed circuit board (PCB). In some embodiments, the systems and methods described herein may be configured to provide a device which allows dissipation of heat from components of a PCB having relatively smaller elevation dimension.

In some embodiments, the systems and methods described herein may be configured to provide a heat dissipating device which has a simple and cost-effective configuration. In some embodiments, the systems and methods described herein may be configured to provide a heat dissipating device which can be manufactured and installed by an economical and simple method of manufacturing.

In some embodiments, the systems and methods described herein may be configured to provide a heat dissipating device for a PCB. In some embodiments, the systems and methods described herein may be configured to allow dissipation of heat from components of a PCB having a relatively small elevation dimension. In some embodiments, the systems and methods described herein may be configured to provide a simple and cost-effective configuration. In some embodiments, the systems and methods described herein may be configured be manufactured and installed by an economical and simple method of manufacturing.

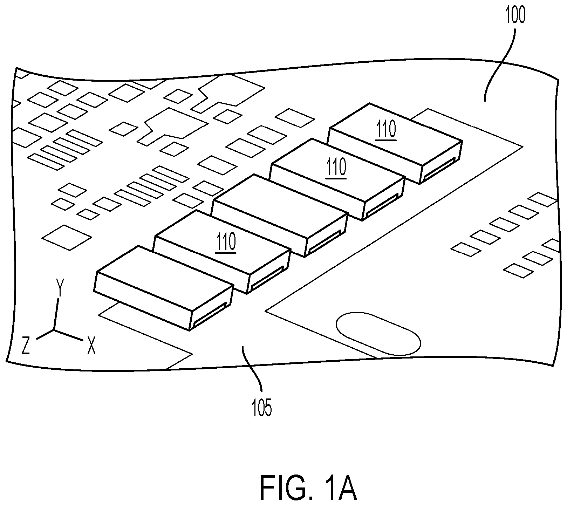

A heat dissipating device (200, 300, 400, 500), according to the principles of the present disclosure, for a PCB (100) is generally illustrated in Figure 1A through Figure 6. The example embodiments described herein does not limit the scope and ambit of the present disclosure.

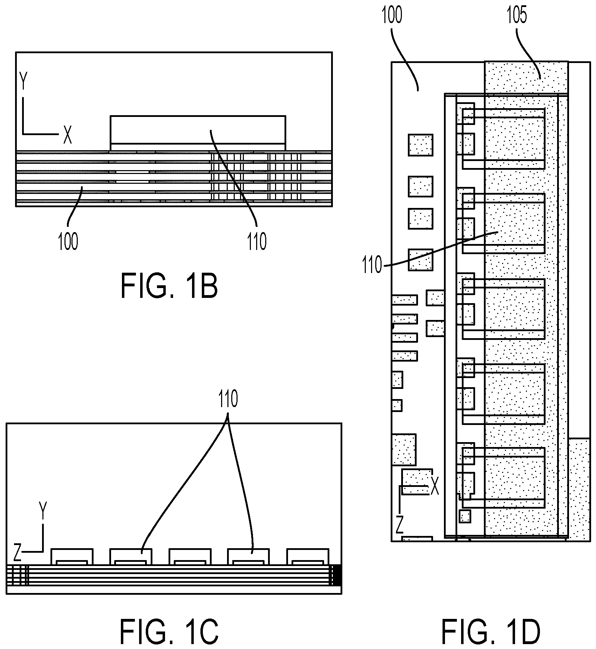

Figure 1A illustrates an isometric view of a PCB (100) having a plurality of heat generating components (110) located thereon. Figure 1B illustrates a front view of the PCB (100) with the heat generating components (110) and copper traces (105) extending therefrom. Figure 1C illustrates a right side view of the PCB (100) with the heat generating components (110). Figure 1D illustrates a top view of the PCB (100) with the heat generating components (110).

The heat dissipating device (hereinafter referred to as 'the device') is configured to dissipate heat generated by the heat generating components (110) of the PCB (100), such as diodes having lesser elevation dimensions and relatively higher heat density.

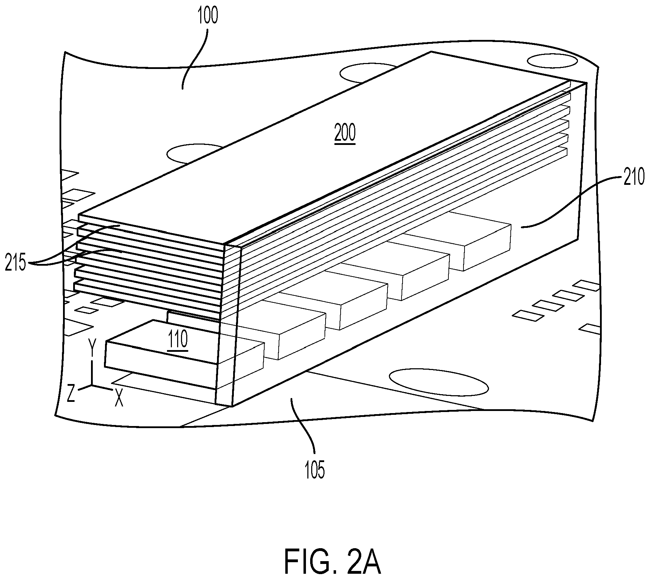

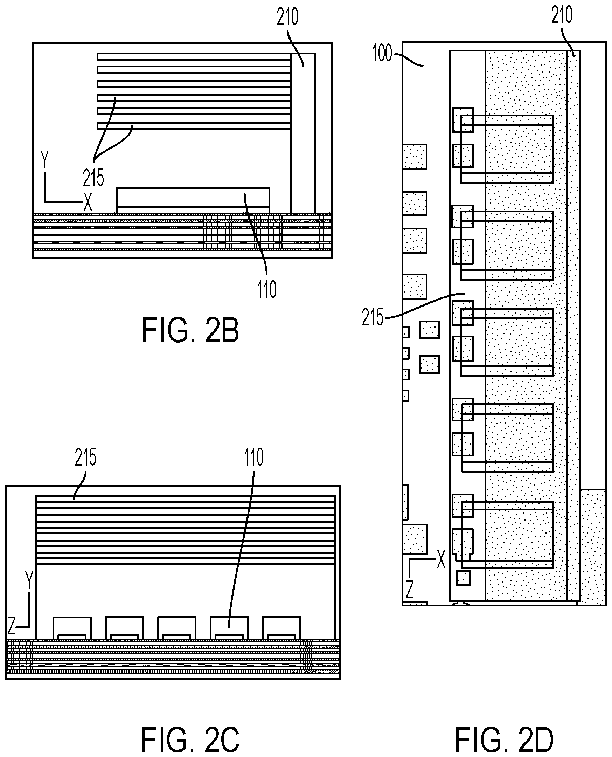

In some embodiments, as shown in Figure 2A through Figure 2D, the device (200) includes an arm (210) extending from a copper trace (105) applied on the PCB (100), in the vicinity of the heat generating component (110), in an operative vertical direction. In some embodiments, the arm (210) is a thin metal plate manufactured from a good conductor of heat such as copper, aluminum, etc. In some embodiments, the arm (210) is of a non- metallic good conductor of heat. The device (200) further includes a plurality of flanges (215) configured to extend from the arm (210) in a direction substantially perpendicular to the operative vertical direction. In some embodiments, each flange (215) is spaced apart from each other by a predetermined distance.

In some embodiments, air is conducting through the PCB (100) via a fan to dissipate heat from the PCB (100). The air stream flowing over the diode and copper trace (105) below the component helps remove an enormous amount of heat from the heat generating component. The flanges (215) when exposed to the stream of air flowing from the fan, helps in ejecting heat accumulated in the heat generating component (110) to reduce its temperature above 200°C to down below 140°C.

In some embodiments, the device (200) further includes a spreader (not shown in figures) provided on the heat generating component (110). The spreader is connected with the arm (210) to facilitate further reduction in the temperature of the component.

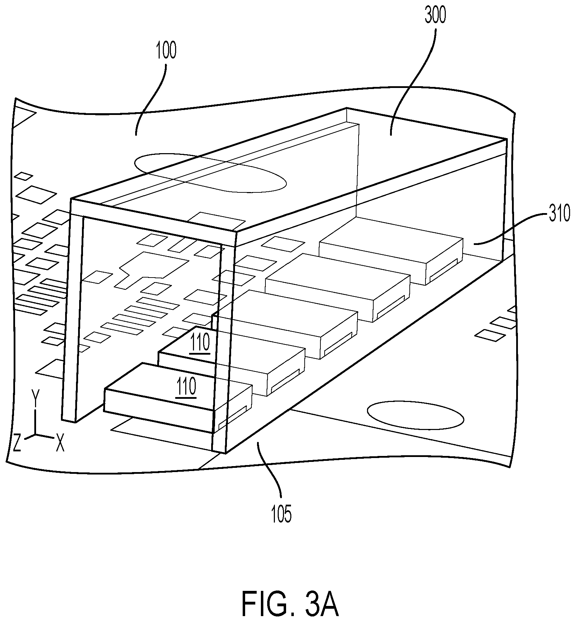

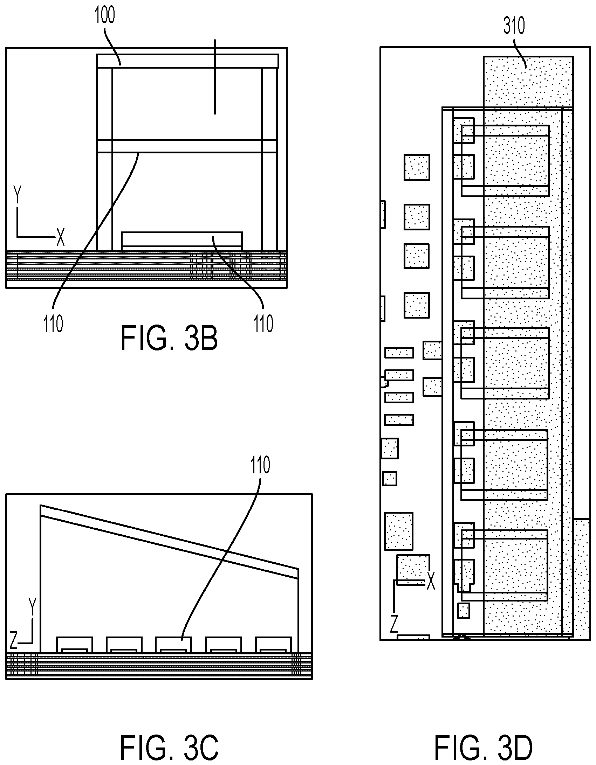

In some embodiments, as shown in Figure 3A through Figure 3D, the device (300) includes a trapezoidal housing (310) extending from a copper trace (105) applied on the PCB (100). The trapezoidal metal housing (310) is introduced over the copper trace (105) to divert the air flowing over the component (110) to remove heat in the component (110). The housing (310) is defined by a large entrance area that tapers towards a smaller exit area to admit more air into the housing, and increase air velocity when it is moving toward the exit area. In some embodiments, the housing (310) can be of a metal material or a non-metallic material to enable diversion of airflow. The housing enables effective dissipation of heat.

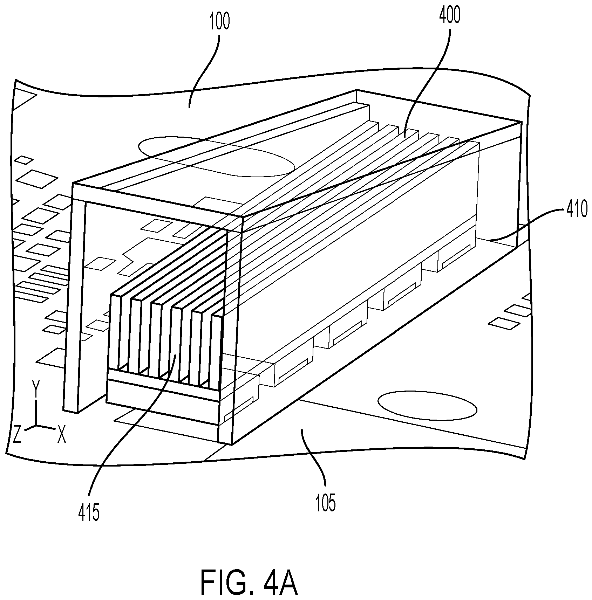

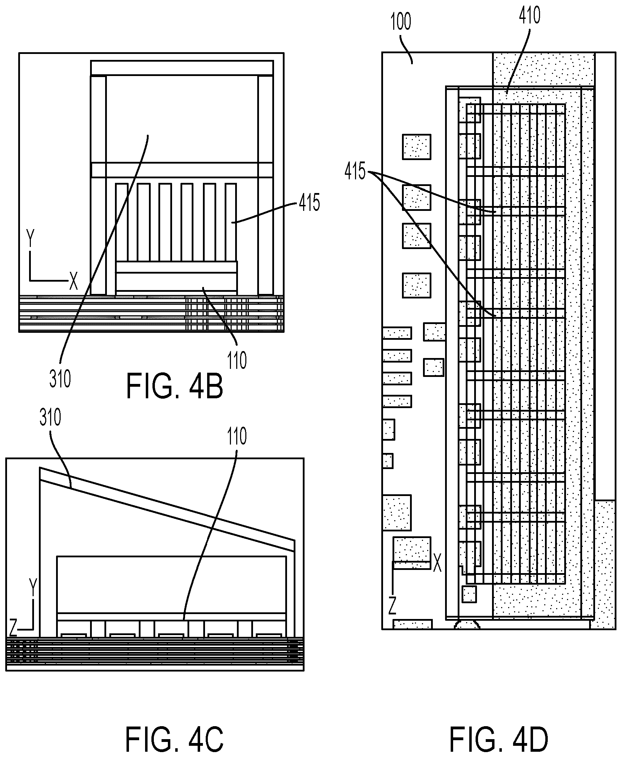

In some embodiments, as shown in Figure 4A through figure 4D, the device (400) includes a trapezoidal housing (410) defined by a large entrance area that tapers towards a smaller exit area to admit more air into the housing (410), along with a heat sink (415) introduced on the surface of the heat generating component (110) to facilitate further reduction in the temperature.

In some embodiments, the device (400) helps in maintaining temperature under 100°C in certain regions of the PCB (100).

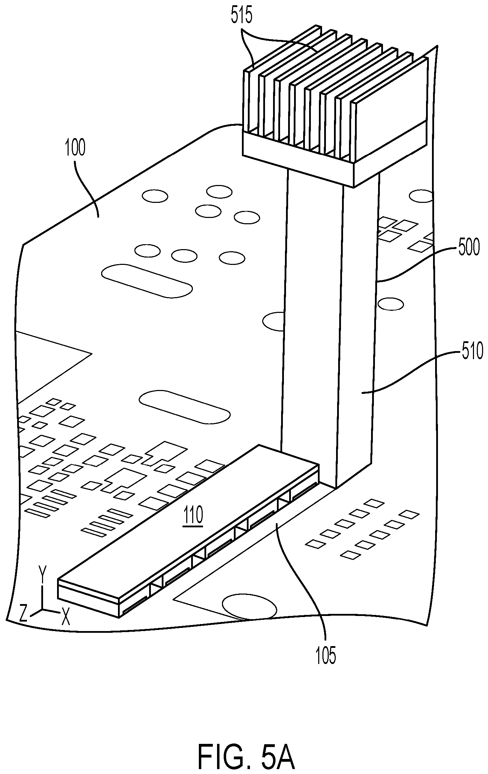

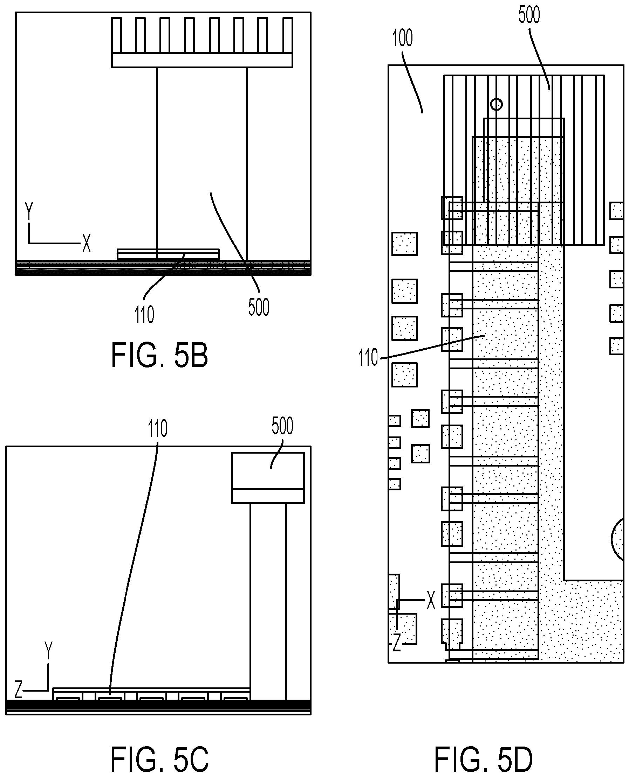

In some embodiments, as shown in Figure 5A through Figure 5D, the device (500) includes a heat pipe (510) configured to extend from a copper trace (105) applied on the PCB (100). The heat pipe (510) is of a good conducting material. In some embodiments, the heat pipe (510) has an evaporator section and a condenser section. In some embodiments, a plurality of flanges (515) may be configured on the condenser section of the heat pipe (510) to further help in dissipation of heat. The evaporator section of the heat pipe (510) is configured to be connected to the copper trace (105), while the condenser section is configured to be connected to a heat sink (not shown in figures) which is exposed to the stream of airflow from the fan to remove heat from the heat pipe (510).

The device (200, 300, 400, 500) of the present disclosure, allows adequate air passage over the diode location, thereby allowing faster heat dissipation.

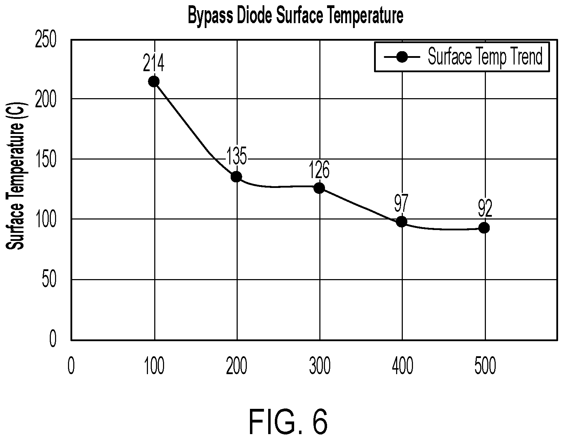

Figure 6 illustrates a graph representing the surface temperature of the heat generating component (110) achieved with the help of each embodiment of the device of the present disclosure. Accordingly, it can be inferred that the device (500), i.e., with the heat pipe (510) facilitates heat dissipation at a better rate than the rest of the embodiments.

The device (200, 300, 400, 500) can be fitted on the PCB (100) can easily be implemented without making any major changes to the existing PCB (100) layout in a cost-effective way. In some embodiments, the device can be employed in any system that needs heat dissipation.

In some embodiments, a heat dissipating device configured to dissipate heat generated by heat generating components of a printed circuit board (PCB) includes: an arm extending from a trace of the PCB proximate a heat generating component; and a plurality of flanges extending from the arm, wherein air flowing from a fan disposed on the PCB interacts with the plurality of flanges causing the plurality of flanges to remove heat from the heat generating component.

In some embodiments, the arm extends from the trace in a direction that is perpendicular to relative to the PCB. In some embodiments, the plurality of flanges extend from the arm in a direction that is parallel to the PCB. In some embodiments, the plurality of flanges extend from the arm over at least a portion of the heat generating component. In some embodiments, the arm is comprised of a metal plate. In some embodiments, the metal plate includes one of a copper plate, and an aluminum plate. In some embodiments, the arm is comprised of a non-metallic plate. In some embodiments, each flange of the plurality of flanges are equally spaced apparat from one another. In some embodiments, the trace includes a copper trace. In some embodiments, the heat generating component includes a diode. In some embodiments, the heat dissipating device also includes a spreader. In some embodiments, the spreader is disposed on the heat generating component at a first portion of the spreader. In some embodiments, the spreader is connected to the arm at a second portion of the spreader.

In some embodiments, a heat dissipating device configured to dissipate heat generated by heat generating components of a printed circuit board (PCB) includes: a trapezoidal housing extending from a trace of the PCB proximate a heat generating component, wherein the trapezoidal housing includes: a first opening disposed at a first end of the trapezoidal housing; and a second opening disposed at a second end of the trapezoidal housing, wherein the first opening is larger than the second opening.

In some embodiments, air flowing from a fan disposed on the PCB enters the trapezoidal housing at the first end. In some embodiments, air flowing from a fan disposed on the PCB exits the trapezoidal housing at the second end. In some embodiments, the trapezoidal housing comprises a metal housing. In some embodiments, the trapezoidal housing comprises a non-metallic housing.

In some embodiments, a heat dissipating device configured to dissipate heat generated by heat generating components of a printed circuit board (PCB) includes: a trapezoidal housing extending from a trace of the PCB proximate a heat generating component; and a heat sink disposed on at least a portion of the heat generating component.

In some embodiments, the trapezoidal housing includes: a first opening disposed at a first end of the trapezoidal housing; and a second opening disposed at a second end of the trapezoidal housing, wherein the first opening is larger than the second opening.

The foregoing description of the embodiments has been provided for purposes of illustration and not intended to limit the scope of the present disclosure. Individual components of a particular embodiment are generally not limited to that particular embodiment, but, are interchangeable. Such variations are not to be regarded as a departure from the present disclosure, and all such modifications are considered to be within the scope of the present disclosure.

The foregoing disclosure has been described with reference to the accompanying embodiments which do not limit the scope and ambit of the disclosure. The description provided is purely by way of example and illustration.

The embodiments herein and the various features and advantageous details thereof are explained with reference to the non-limiting embodiments in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

The foregoing description of the specific embodiments so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while example embodiments herein have been described, those skilled in the art will recognize that the embodiments herein can be practiced with modification within the scope of the embodiments as described herein.

Any discussion of materials, devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

The numerical values mentioned for the various physical parameters, dimensions or quantities are only approximations and it is envisaged that the values higher/lower than the numerical values assigned to the parameters, dimensions or quantities fall within the scope of the disclosure, unless there is a statement in the specification specific to the contrary.

While considerable emphasis has been placed herein on the components and component parts of the described embodiments, it will be appreciated that many embodiments can be made and that many changes can be made in the described embodiments without departing from the principles of the disclosure. These and other changes in the described embodiment as well as other embodiments of the disclosure will be apparent to those skilled in the art from the disclosure herein, whereby it is to be distinctly understood that the foregoing descriptive matter is to be interpreted merely as illustrative of the disclosure and not as a limitation.

The disclosure comprises the following items:
1. A heat dissipating device configured to dissipate heat generated by heat generating components of a printed circuit board (PCB), the heat dissipating device comprising:
   an arm extending from a trace of the PCB proximate a heat generating component; and
   a plurality of flanges extending from the arm, wherein air flowing from a fan disposed on the PCB interacts with the plurality of flanges causing the plurality of flanges to remove heat from the heat generating component.
2. The heat dissipating device of item 1, wherein the arm extends from the trace in a direction that is perpendicular to relative to the PCB.
3. The heat dissipating device of any preceding item, wherein the plurality of flanges extend from the arm in a direction that is parallel to the PCB.
4. The heat dissipating device of any preceding item, wherein the plurality of flanges extend from the arm over at least a portion of the heat generating component.
5. The heat dissipating device of any preceding item, wherein the arm is comprised of a metal plate.
6. The heat dissipating device of any preceding item, wherein the metal plate includes one of a copper plate, and an aluminum plate.
7. The heat dissipating device of any preceding item, wherein the arm is comprised of a non-metallic plate.
8. The heat dissipating device of any preceding item, wherein each flange of the plurality of flanges are equally spaced apparat from one another.
9. The heat dissipating device of any preceding item, wherein the trace includes a copper trace.
10. The heat dissipating device of any preceding item, wherein the heat generating component includes a diode.
11. The heat dissipating device of any preceding item, further comprising a spreader.
12. The heat dissipating device of any preceding item, wherein the spreader is disposed on the heat generating component at a first portion of the spreader.
13. The heat dissipating device of any preceding item, wherein the spreader is connected to the arm at a second portion of the spreader.
14. A heat dissipating device configured to dissipate heat generated by heat generating components of a printed circuit board (PCB), the heat dissipating device comprising:
   a trapezoidal housing extending from a trace of the PCB proximate a heat generating component, wherein the trapezoidal housing includes:
   a first opening disposed at a first end of the trapezoidal housing; and
   a second opening disposed at a second end of the trapezoidal housing,
   wherein the first opening is larger than the second opening.
15. The heat dissipating device of item 14, wherein air flowing from a fan disposed on the PCB enters the trapezoidal housing at the first end.
16. The heat dissipating device of item 14 or 15, wherein air flowing from a fan disposed on the PCB exits the trapezoidal housing at the second end.
17. The heat dissipating device of any of items 14-16, wherein the trapezoidal housing comprises a metal housing.
18. The heat dissipating device of any of items 14-17, wherein the trapezoidal housing comprises a non-metallic housing.
19. A heat dissipating device configured to dissipate heat generated by heat generating components of a printed circuit board (PCB), the heat dissipating device comprising:
   a trapezoidal housing extending from a trace of the PCB proximate a heat generating component; and
   a heat sink disposed on at least a portion of the heat generating component.
20. The heat dissipating device of item 19, wherein the trapezoidal housing includes: a first opening disposed at a first end of the trapezoidal housing; and a second opening disposed at a second end of the trapezoidal housing, wherein the first opening is larger than the second opening.

## Claims

1. A heat dissipating device configured to dissipate heat generated by heat generating components of a printed circuit board, PCB, the heat dissipating device comprising:
an arm extending from a trace of the PCB proximate a heat generating component; and
a plurality of flanges extending from the arm and configured to interact with air flowing from a fan disposed on the PCB to cause the plurality of flanges to remove heat from the heat generating component.

2. The heat dissipating device of claim 1, wherein the arm extends from the trace in a direction that is perpendicular to the PCB.

3. The heat dissipating device of claim 1 or claim 2, wherein the plurality of flanges extend from the arm in a direction that is parallel to the PCB.

4. The heat dissipating device of any preceding claim, wherein the plurality of flanges extend from the arm over at least a portion of the heat generating component.

5. The heat dissipating device of any preceding claim, wherein the arm is comprised of a metal plate.

6. The heat dissipating device of claim 5, wherein the metal plate includes one of a copper plate, and an aluminum plate.

7. The heat dissipating device of any of claims 1-4, wherein the arm is comprised of a non-metallic plate.

8. The heat dissipating device of any preceding claim, wherein each flange of the plurality of flanges are equally spaced appart from one another.

9. The heat dissipating device of any preceding claim, wherein the trace includes a copper trace.

10. The heat dissipating device of any preceding claim, wherein the heat generating component includes a diode.

11. The heat dissipating device of any preceding claim, further comprising a spreader.

12. The heat dissipating device of claim 11, wherein the spreader is disposed on the heat generating component at a first portion of the spreader.

13. The heat dissipating device of claim 12, wherein the spreader is connected to the arm at a second portion of the spreader.
